# EUROPEAN PATENT APPLICATION

(11) **EP 1 566 854 A1**
(43) Date of publication of application: **24.08.2005**
(21) Application number: 04405093.8
(22) Date of filing: 19.02.2004
(51) Int. Cl.: H01L 51/20

(54) **Organic light emitting device**

(71) Applicant: Heptagon Oy, 02150 Espoo (FI)
(72) Inventor: Rudmann, Hartmut, 8400 Winterthur (CH); Rossi, Markus, 8645 Jona (CH)
(74) Representative: Frei Patent Attorneys

(57) **Abstract**

An organic light emitting device comprises a substrate, a first electrode (22) layer, a second electrode (23) and an organic layer comprising electroluminescent material (21) sandwiched between the two electrodes and supported by a substrate (24). The first electrode and the substrate are transparent for radiation emitted by the light emitting layer (21). According to the invention, the organic layer (21) and the first electrode layer (22) are wave shaped. By this, waveguiding effects in the transparent layers may be reduced, and the out-coupling efficiency may be enhanced.

## Description

### FIELD OF THE INVENTION

This invention concerns an electroluminescent element and more particularly concerns an organic light emitting device.

### BACKGROUND OF THE INVENTION

Organic light emitting devices (OLEDs) are a recent invention where organic electroluminescent materials (polymeric materials or small molecule materials) are being used for active light emission. For that purpose, the organic material is sandwiched between two electrode layers. In the sandwich structure, the layer thickness of the organic material is typically in the range of 20-150 nm. Also multilayers of different organic materials are possible. One of the two electrodes has to be transparent in order to let the light escape the device. An example of a transparent electrode is indium tin oxide (ITO). The other electrode is typically a metal electrode, preferably from a low work function metal such as Magnesium. The overall thickness of the active components in an OLED (electrodes + organic layer) are in the range of 0.2 - 1 µm. The OLED typically comes on a transparent substrate such as glass to ensure mechanical integrity of the system.

Due to the thin layer like structure of OLEDs out-coupling of the light is a problem. The out-coupling of light refers to the fraction of created light within the device that is actually being emitted through the front surface of the device. For a typical OLED the out-coupling fraction is in the range of 20-40%. The rest of the light (80-60%) is lost due to wave guiding or wave guiding like mechanisms in the individual layers caused by differences of index of refraction of employed materials. As a result of wave guiding, most of the created light in the device is leaving the OLED, usually not being useable, at the edge and not through the substrate surface.

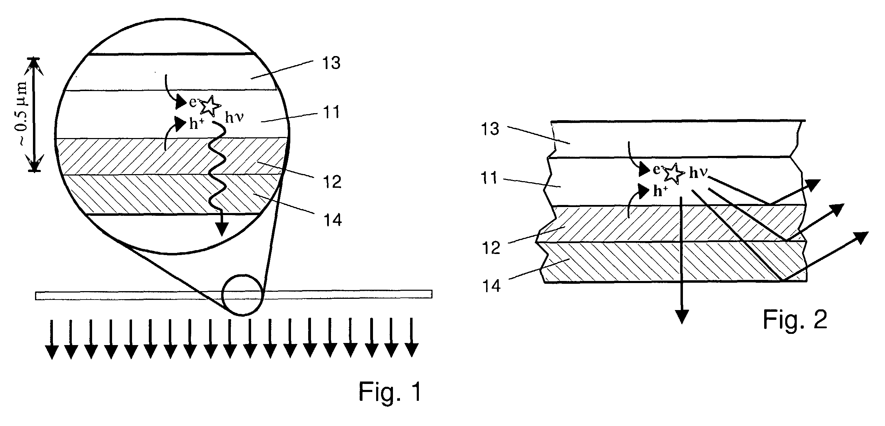

**Figure 1** shows the layer structure of a typical OLED 1. During operation, light emission occurs in the organic light emitting (electroluminescent) layer 11 due to injection of charge carriers (holes and electrons) from a transparent electrode 12 and an intransparent electrode 13. Light created in the electroluminescent layer 11 can leave the device through the transparent electrode 12 and the substrate 14. The total thickness of the OLED (without substrate) is in the range of 0.2 - 1.0 µm. The intransparent electrode 13 - often it is the cathode -also acts as mirror.

**Figure 2** shows the mechanism of wave guiding by means of arrows. Because of the different index of refraction of the materials light can be reflected at the interfaces of the layers. As a consequence the reflected light is guided to the edge of the OLED.

Several approaches have been suggested to increase the out-coupling such as micro lenses on the substrate, micro cavities or additional layers with a low index of refraction.

### SUMMARY OF THE INVENTION

It is an object of this invention to provide an alternative, efficient and easy-to-realise solution to the out-coupling problem and to provide a novel way of increasing out-coupling of OLEDs.

According to the invention, the transparent electrode and the electroluminescent layer both exhibit a micro-optical structure that increases out-coupling. An approach of the invention is to provide the transparent electrode and the micro-optical structure with a wave shape. This is for example achieved by modifying the substrate surface with a wave shape structure, such that the waviness is imposed on the following layer structure of the OLED.

The meaning of "wave shape" in this context may best be explained with reference to a coordinate system. The essentially plane device and its layers define an x-y-plane, whereas the z direction is perpendicular to the device. A layer in this context has a "wave shape" if its thickness (i.e. its dimension in z direction) and/or the z position of the according layer varies smoothly and non-monotonously as a function of the lateral position (i.e. the x- and/or y-position). "Wave shape" is not restricted to strictly periodical dependencies but refers to any dependency, where thickness and/or z position, depending on a certain lateral position have alternate ascending and descending sections. This includes quasi-periodical structures, modulated structures etc.

Due to the waviness, an out-coupling enhancement of such a structured device is achieved. This enhancement comes from the micro optical design of the waviness. The waviness avoids wave guiding in the individual layers of the OLED.

The modification of the substrate with a wave shape structure may be achieved by providing an intermediate layer with an uneven thickness, that is for example wave shaped. As an alternative, the waviness may be imposed on a one-piece substrate with a wavy surface. Such a wavy surface may be achieved by any method known in the art, for example by (roll to roll) hot embossing or pressing, or by any replication method for a substrate or intermediate layer.

The waviness may be a 1-D-waviness, where z position and/or thickness of the electroluminescent layer and transparent electrode varies, depending on a lateral coordinate, in one direction, whereas it is not dependent on the position in a direction orthogonal thereto. As a - preferred - alternative, the waviness is a 2D-waviness: The z-position of the layers varies as a function of both lateral coordinates. If the waviness is 2D-the wavelength for both directions does not necessarily have to be identical.

According to a preferred embodiment, the typical dimensions of the wave function such as the average wavelength and the amplitude are much larger than the typical thickness dimensions of the electroluminescent layer. The dimensions may be in the range of between 5 µm and 100 µm, preferably between 10 µm and 50 µm for the wavelength, a condition being that the wavelength of the waviness is greater than the light wavelength by a large factor of, for example at least 5 or at least 10. The waviness amplitude may be between 0.3 µm and 20 µm, preferably between 0.5 µm and 10 µm. By choosing such an approach, the surface of the patterned substrate appears locally flat to the OLED. This local flatness is beneficial for practical reasons. Typical fabrication methods for OLEDs are evaporation or solvent based methods such as spin coating. Any sharp edges in the structure of the OLED will lead to problems during the fabrication such as electrical shortage of a device or thickness variations in the electroluminescent layer. Therefore, by allowing a substrate waviness that appears locally flat no such fabrication problems should occur. A potential "local flatness" requirement goes into the design as boundary condition.

The optical design can be optimized for certain wavelengths, i.e. colors of an OLED. In addition to the increased out-coupling, the angular distribution of the light emission can be modified by choosing an appropriate design. For example, with a certain micro-optical design, the emission in forward direction of a device could be enhanced compared to the typical Lambertian emission characteristic of an OLED.

Micro-optics, as opposed to conventional optics, is based on fine structures causing refraction and/or diffraction, the structures having characteristic depths/heights and often also widths of typically a few micrometers (µm), for example of 0.5 µm - 200 µm, preferably of between 0.5 µm and about 50 µ. In other words, the characteristic profile depths and the profile widths are of the order of a few wavelengths up to a few tens of wavelengths for refractive optics and of about one wavelength up to a few wavelengths for diffractive optics. As a rule of thumb, micro-optical elements have structures such that the phase relation of radiation present at different neighboring places on the structure is well-defined.

A wave structure having the desired properties may be designed using micro-optical design including for example the following process steps:
1. The light emitting layer is modeled as a three dimensional array of virtual point sources with emission characteristics selected to match the emission characteristics of the OLED. The size of the array depends both on the physical dimensions of the emitting layer considered, the selected model of interaction with optical interfaces, and the required precision of the simulation, being typically in range of few thousand to few hundred thousand individual sources.
2. The interaction of the light emitted by the virtual point sources with the different layers of the OLED is considered using a suitable optical simulation model, typically non-sequencial ray tracing or a more precise method based on description of the light as electromagnetic waves.
3. An ideal wave shape is typically found by designing the optimum wave shape first individually for each virtual point individually and then combinining all the solutions by a weighted summation to obtain the ideal wave shape for the considered OLED and the desired output pattern. The weights for the summation are calculated by considering how much energy each virtual source contributes to each spot on the exit surface, i.e. weights correspond to relative intensities of each source at each point. Alternatively it is possible to simultaneously consider a larger number of virtual sources that are for example in close proximity and solve the optimum wave shape for such groupings of sources before again obtaining the ideal wave shape via weighted summation. Finally, in some special cases where the size of point source array is relatively small, for example due to representing a small emitting layer, it is possible to consider all sources simultaneously thus removing the need for the weighted summing step at the end of the process.

### BRIEF DESCRIPTION OF THE DRAWINGS

In the following, embodiments of the invention are described with reference to schematical drawings. In the drawings
- Fig. 1 shows an OLED according to the state of the art
- Fig. 2 sketches the problem of waveguiding in the different layers
- Fig. 3 shows an embodiment of a layer structure of an OLED according to the invention
- Fig. 4 represents an embodiment of the invention, further comprising refractive micro-optical structures for collimating and outcoupling the emitted radiation

### DESCRIPTION OF THE PREFERRED EMBODIMENTS

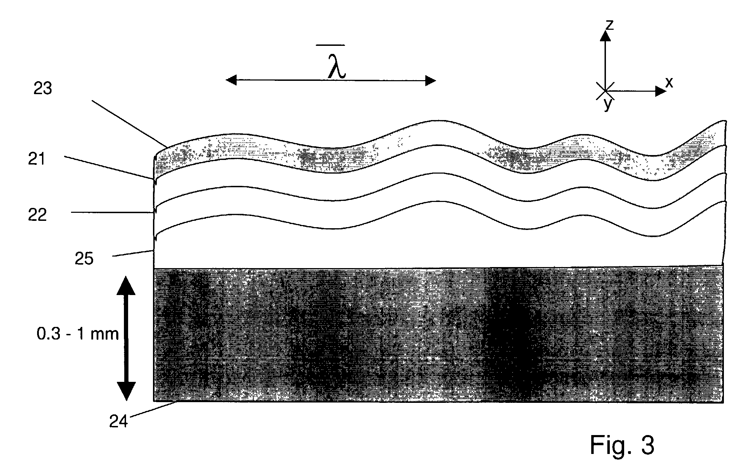

The layered structure according to the invention is shown in Figure 3 A first, transparent electrode 22 and a second, intransparent and preferably (but not necessarily) light reflecting electrode 23 sandwich an electroluminescent layer 21. The substrate, on which these layers are arranged, comprises a transparent carrier element 24, for example a glass plate, and further comprises a transparent polymer (or other material) layer 25 with uneven thickness as an intermediate layer. In the shown example, the intermediate layer 25 has a wave shape structure because it is corrugated. The waviness of the structure is imposed on the following layer structure of the OLED. In the shown embodiment, typical dimensions of the wave function such as average wavelength λ and the amplitude are much larger than the typical dimensions of an OLED layer, such as 10-50 µm for the wavelength and 0.5-10 µm for the amplitude. By choosing such an approach, the surface of the patterned substrate appears locally flat to the OLED.

The material compositions of the individual layers may be chosen as follows:

### Example 1:

Top Electrode (second electrode) Mg:Ag
Organic layer (being a heterostructure made up of different layers; from top to bottom): Alq₃ (tris-(8-hydroxyquinoline)aluminum)(electroluminescent material); TPD (N,N'-diphenyl-N,N'-bis(3-methylphenyl)1-1'biphenyl-4,4'diamine); PEDOT/PSS (poly(3,4-ethylenedioxythiophene)/poly(styrenesulfonate))
Transparent Electrode (bottom electrode): ITO (Indium Tin oxide)
Substrate: Glass

### Example 2

Top Electrode (second electrode): Mg:Ag
Organic layer (being a heterostructure made up of different layers; from top to bottom): MEH-PPV (poly[2-methoxy-5-(2-ethylhexyloxy)-1,4-phenylenevinylene]) (electroluminescent material); PEDOT:PSS
Transparent electrode (bottom electrode): ITO

### Substrate: glass

A possible intermediate layer may as shown in the figures be of any transparent material, for example of UV curable epoxy or any other suitable material.

Although the figure being a section of an embodiment illustrates waviness only in one dimension, the device will preferably exhibit a 2-D-waviness. This means that the thickness of the polymer layer 25 - in the shown embodiment - or of the substrate carrier element 24 or of other layers varies as a function of both lateral coordinates x and y (see Cartesian coordinate system). Depending on the geometry and on other requirements, the geometry in the two lateral directions may be the same or may be different.

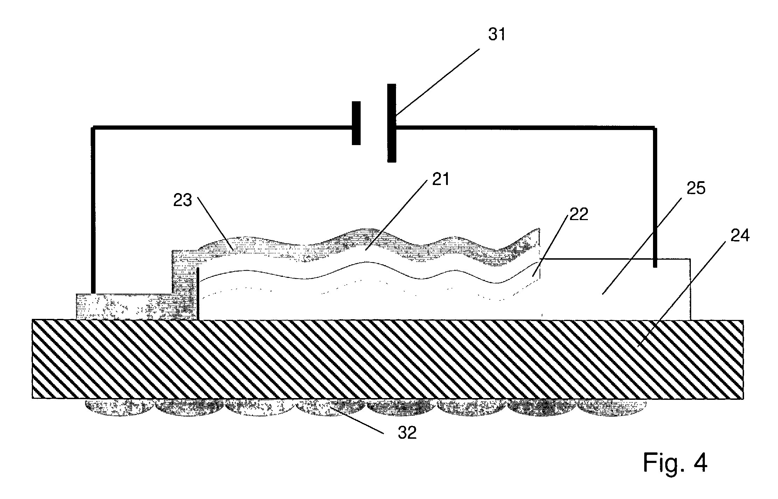

**Figure 4** schematically shows the layered structure of the OLED including power supply means 31 for causing a voltage between the two electrodes 22, 23. The OLED further comprises diffractive and/or refractive micro-optical out-coupling structures 32 which additionally enhance outcoupling and/or otherwise influence the outcoupled light, for example by enhancing the intensity in a particular desired direction. The out-coupling structures in the shown embodiment are provided on the one surface of the substrate that is opposite the mentioned layers. The out-coupling structures may be provided in the substrate itself, for example by replication, or may be provided in an additional layer, into which they are replicated. They even may comprise a plurality of individual elements applied to the substrate surface, for example micro-spheres or micro-lenses.

The shown embodiments show a 'standard' sequence of layers, including a reflecting 'top' electrode, where light is coupled out through the substrate. The invention, however, also comprises OLEDs with different sequences of layers. For example, set-ups may be envisaged, where light is not coupled out through the substrate but where the intransparent electrode is directly provided on the substrate (potentially comprising a corrugated intermediate layer). As yet another alternative, the substrate itself may be intransparent and/or serve as electrode. In these embodiments, the generated light is coupled out directly from the transparent electrode, potentially through at least one additional transparent protection layer.

## Claims

1. An organic light emitting device comprising a substrate, a first electrode (22) layer, a second electrode (23) and an organic layer comprising electroluminescent material (21) sandwiched between the two electrodes, the first electrode, the light emitting layer and the second electrode being supported by the substrate, wherein the first electrode is transparent for radiation emitted by the organic layer (21), **characterized in that** organic layer (21) and the first electrode layer (22) are wave shaped.

2. An organic light emitting device according to claim 1, wherein the first electrode and organic layer (21) are provided on a corrugated base.

3. An organic light emitting device according to claim 1 or 2, wherein the substrate is transparent, wherein a transparent intermediate layer (25) having an uneven thickness is provided on a surface of the substrate, and wherein the first electrode layer (22) and the light emitting layer are provided on the intermediate layer (25), and wherein the second electrode is provided on the organic layer (21).

4. An organic light emitting device according to claim 3, comprising on a side of the substrate opposed to the mentioned layers, outcoupling structures operable to enhance outcoupling of radiation from the substrate and/or to influence properties of outcoupled light.

5. An organic light emitting device according to any one of the preceding claims, wherein the layered structure is locally flat such that the characteristic dimensions of all variations of thicknesses and/or positions of layers are larger than the wavelength of emitted light.

6. An organic light emitting device according to any one of the preceding claims, wherein the substrate and the mentioned layers define an x-y-plane of a Cartesian coordinate system, wherein the thickness and/or the z-position of the organic electroluminescent layer and of the first electrode vary, as a function of the x- and/or y position periodically or quasi-periodically, wherein the wavelength of said variation is in the range of between 5 µm and 100 µm, and wherein the amplitude of said variation is in the range between 0.5 µm and 10 µm.

7. An organic light emitting device according to any one of the preceding claims, wherein the wave shape is formed, by means of a micro-optical design, in a manner that the emission characteristics is optimised to match a specific target characteristics.
